# EUROPEAN PATENT APPLICATION

(11) **EP 4 811 946 A1**
(43) Date of publication of application: **23.09.2026**
(21) Application number: 26166144.1
(22) Date of filing: 19.03.2026
(51) Int. Cl.: H05K 7/20, G06F 1/20

(54) **MODULAR DATA CENTER SYSTEM**

(30) Priority: 19.03.2025 US 202563774468 P; 13.03.2026 US 202619566438
(71) Applicant: Vertiv International GmbH, 8212 Neuhausen am Rheinfall (CH)
(72) Inventor: NAMLIC, Denis, 8212 Schaffhausen (CH); PERINOVIC, Domagoj, 8212 Schaffhausen (CH); SMOLCIC , Juraj, 8212 Schaffhausen (CH)
(74) Representative: Beal, James Michael

(57) **Abstract**

A cooling system may include one or more coolant distribution units (CDUs) to regulate a distribution of a coolant and a secondary fluid network coupled to the CDUs. The secondary fluid network may include one or more main pipelines coupled to the CDUs, where the main pipelines may be arranged in a hot aisle formed by at least two rack rows including a plurality of racks. The secondary fluid network may include one or more branch pipes coupled to the main pipelines, where the branch pipes may be arranged with the hot aisle below the main pipelines. The secondary fluid network may include conduits to couple the branch pipes to the plurality of racks. The main pipelines may distribute the coolant from the CDUs to the branch pipes and the branch pipes may distribute the coolant to the plurality of racks via the conduits.

## Description

### CROSS-REFERENCE TO RELATED APPLICATIONS

The present application claims the benefit of U.S. Provisional Application No. 63/774,468, filed March 19, 2025, and of U.S. Non-Provisional Application No. 19/566,438, filed March 13, 2026.

### TECHNICAL FIELD

The present disclosure generally relates to the field of cooling systems, and more particularly, to a cooling system for a modular data center.

### BACKGROUND

The rise of artificial intelligence (Al) and machine learning (ML), alongside high-performance computing, has created new challenges for cooling systems in data centers. For example, Al and ML models require training, which is often performed in high-performance data centers. As chip, server, and rack densities increase, traditional air-cooling methods struggle to manage the resulting heat levels effectively on their own. This has resulted in an increase in demand for liquid cooling systems.

However, one challenge with liquid cooling systems is the secondary fluid network. For example, the placement of pipes and related pipe elements poses considerable difficulties due to space constraints within the cooling system. It is important that the components of the secondary fluid network remain accessible to facilitate manipulation and maintenance, while also minimizing the risk of leakage. In conventional designs, the secondary fluid network is installed above the racks (e.g., in the ceiling). In such designs, the pipe positioning and routing increases the risk of leakage, requires more space, and inhibits accessibility for maintenance and manipulation.

Therefore, there is a need for a system which cures one or more shortfalls of the above approaches.

### SUMMARY

In embodiments, a modular data center system includes: a modular enclosure including a plurality of walls that define a cavity; at least two rack rows housed within the cavity of the modular enclosure, the at least two rack rows including at least a first rack row and a second rack row, where the first rack row is arranged a select distance from the second rack row to form a hot aisle, where each rack row includes a plurality of racks; one or more coolant distribution units configured to regulate a distribution of a coolant; and a secondary fluid network coupled to the one or more coolant distribution units, where the secondary fluid network includes: one or more main pipelines coupled to the one or more coolant distribution units, where the one or more main pipelines are arranged in the hot aisle; one or more branch pipes coupled to the one or more main pipelines, where the one or more branch pipes are arranged with the hot aisle below the one or more main pipelines; and one or more conduits configured to couple the one or more branch pipes to the plurality of racks of the at least two rack rows, where the one or more main pipelines distribute the coolant from the one or more coolant distribution units to the one or more branch pipes, where the one or more branch pipes distribute the coolant to the plurality of racks via the one or more conduits.

In embodiments, a liquid cooling system includes: one or more coolant distribution units configured to regulate a distribution of a coolant; and a secondary fluid network coupled to the one or more coolant distribution units, where the secondary fluid network includes: one or more main pipelines coupled to the one or more coolant distribution units, where the one or more main pipelines are arranged in a hot aisle formed by at least two rack rows including a plurality of racks; one or more branch pipes coupled to the one or more main pipelines, where the one or more branch pipes are arranged with the hot aisle below the one or more main pipelines; and one or more conduits configured to couple the one or more branch pipes to the plurality of racks of the at least two rack rows, where the one or more main pipelines distribute the coolant from the one or more coolant distribution units to the one or more branch pipes, where the one or more branch pipes distribute the coolant to the plurality of racks via the one or more conduits.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.

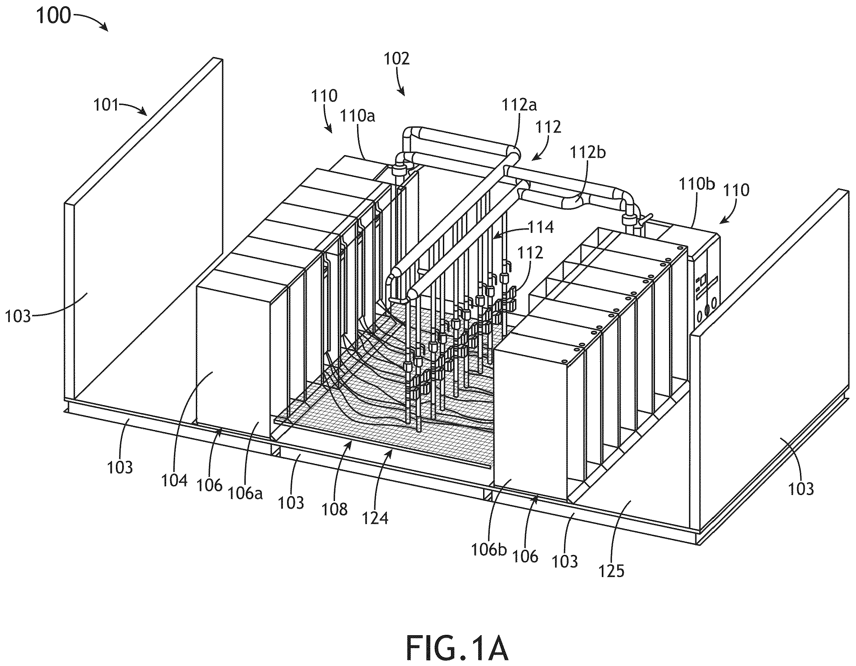

FIG. 1A is a simplified schematic of a modular data center system including a secondary fluid network, in accordance with one or more embodiments of the present disclosure.

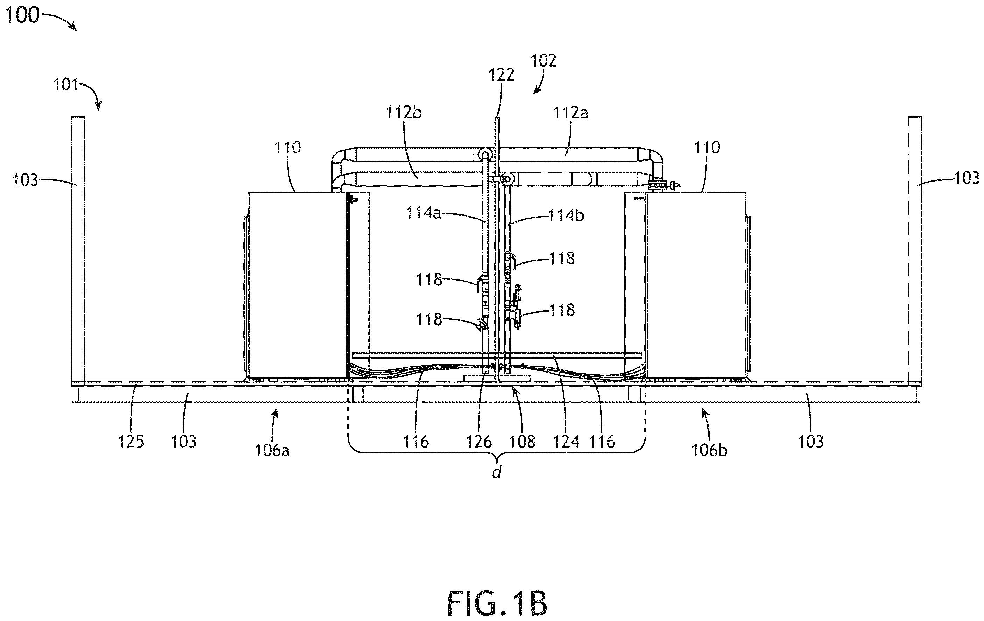

FIG. 1B is a simplified side view of the modular data center system including the secondary fluid network, in accordance with one or more embodiments of the present disclosure.

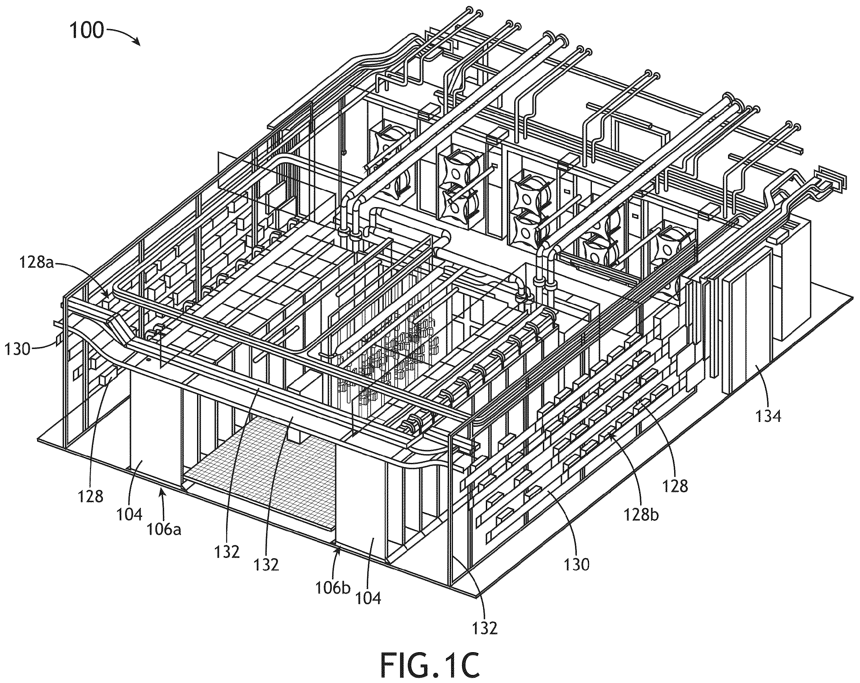

FIG. 1C is a simplified schematic of the modular data center system including the secondary fluid network, in accordance with one or more embodiments of the present disclosure.

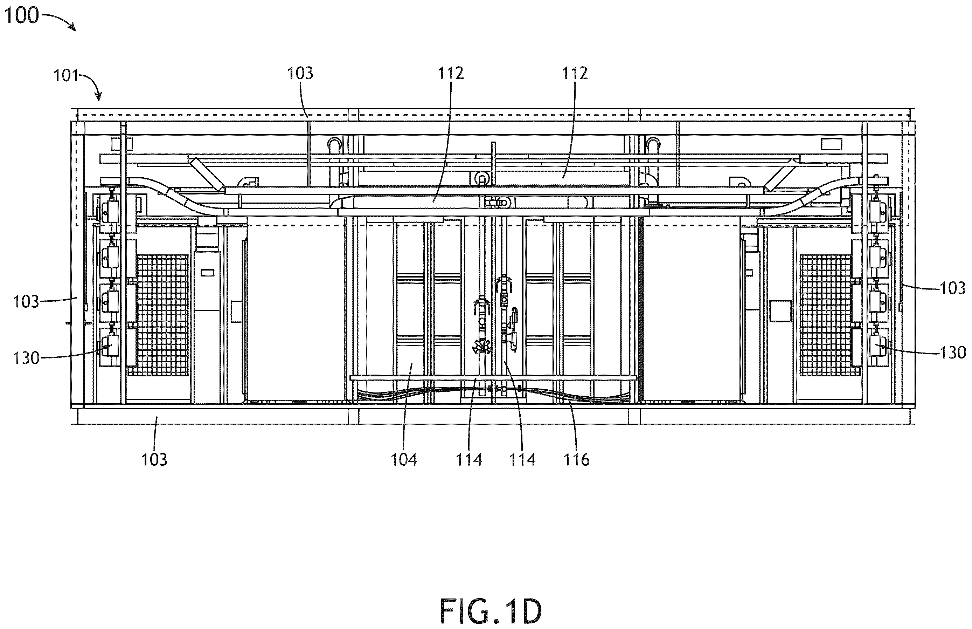

FIG. 1D is a simplified side view of the modular data center system including the secondary fluid network, in accordance with one or more embodiments of the present disclosure.

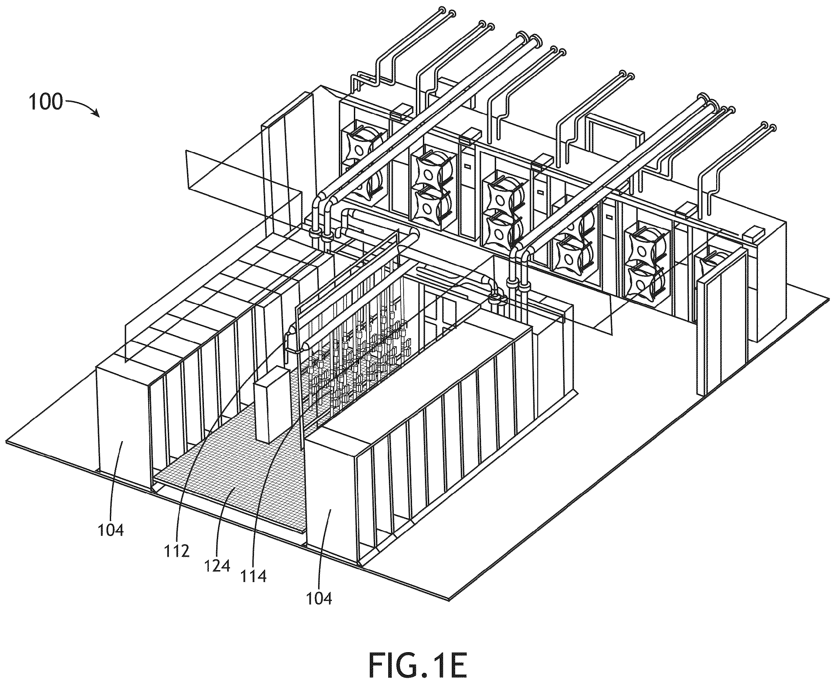

FIG. 1E is a simplified schematic of the modular data center system including the secondary fluid network, in accordance with one or more embodiments of the present disclosure.

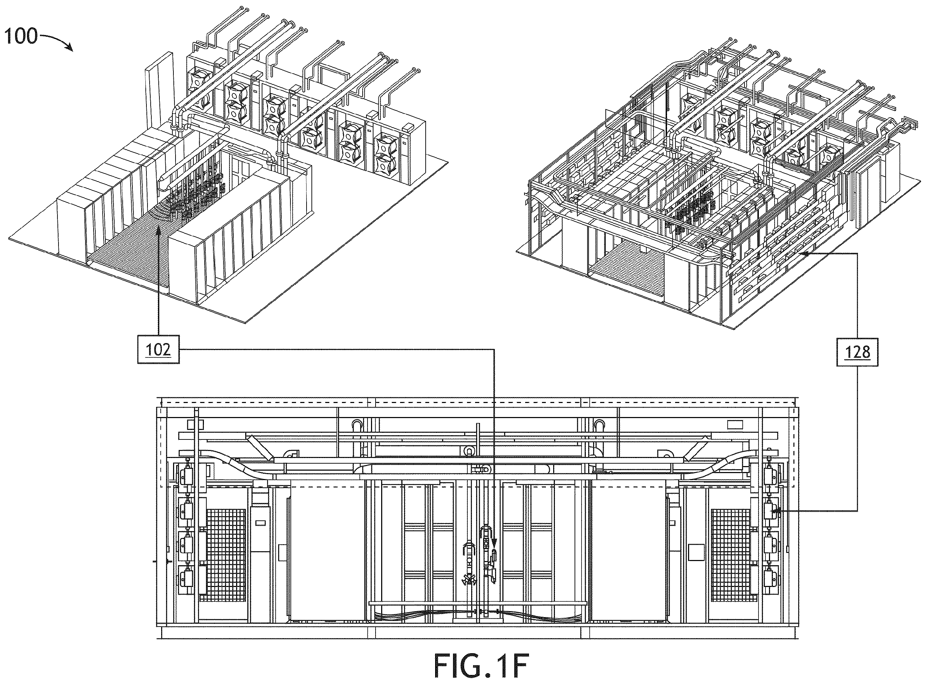

FIG. 1F is a simplified schematic of the modular data center system including the secondary fluid network, in accordance with one or more embodiments of the present disclosure.

### DETAILED DESCRIPTION

Reference will now be made in detail to the subject matter disclosed, which is illustrated in the accompanying drawings.

Embodiments of the present disclosure are directed to a modular data center system. In particular, embodiments of the present disclosure are directed to a modular data center system including a liquid cooling system, where the liquid cooling system includes a secondary fluid network. The secondary fluid network may be configured to increase the space available for other infrastructure and decrease the risk of leakage. For example, the secondary fluid network may be arranged in the hot aisle formed by the racks, which decreases the risk of leaks since piping and valves are not arranged above the racks (as is the case with conventional designs) and also opens up space for other infrastructure. In the event that a leakage happens, fluid from the secondary fluid network may fall into a drain pan located beneath a grating of the hot aisle and not on the rack equipment itself.

Further, the secondary fluid network may be configured to provide easier accessibility to pipe elements to allow for proper equipment manipulation and maintenance. For example, the valves on the pipes may be easily accessed in the hot aisle, such that data center personnel can manipulate the valves via the hot aisle. The secondary fluid network may be compact such that it can be transported in a single module and also can be scaled based on customer needs.

FIGS. 1A-1F illustrate a modular data center system 100 including a secondary fluid network 102 of the present disclosure, in accordance with one or more embodiments of the present disclosure.

In embodiments, the modular data center system 100 includes an enclosure 101 configured to house one or more components of the system 100. For example, the enclosure 101 may be configured to house a power and cooling system. By way of another example, the enclosure 101 may be configured to house equipment (e.g., supporting data center equipment, or the like).

The enclosure 101 may be formed of a plurality of walls 103 that define at least one cavity configured to house the components of the system 100. In a non-limiting example, the enclosure 101 may include an outdoor enclosure. In an additional non-limiting example, the enclosure 101 may include an indoor enclosure.

The modular data center system 100 may include a liquid cooling system. For example, the modular data center system 100 may include a direct-to-chip liquid cooling system within the cavity of the enclosure 101. The liquid cooling system of the modular data center system 100 may include the secondary fluid network 102 arranged within a hot aisle of the modular data center system 100 (as will be discussed further herein). For example, the secondary fluid network 102 may be configured to provide a steady flow of coolant directly to information technology (IT) equipment within the modular data center system 100. For instance, the secondary fluid network 102 may be configured to provide coolant directly to IT equipment within a plurality of racks 104.

The plurality of racks 104 may be arranged in at least two rack rows 106. For example, the modular data center system 100 may include at least two rack rows 106, where each rack row 106 includes the plurality of racks 104. In a non-limiting example as shown in FIG. 1A, each rack row 106 may include seven (7) racks, where each rack may be configured to hold respective IT equipment. In an additional non-limiting example as shown in FIG. 1C, each rack row 106 may include twelve (12) racks, where each rack may be configured to hold respective IT equipment. In an additional non-limiting example as shown in FIG. 1E, each rack row 106 may include ten (10) racks, where each rack may be configured to hold respective IT equipment. It is noted herein that FIGS. 1A-1F are provided merely for illustrative purposes and shall not be construed as limiting the scope of the present disclosure. As such, the plurality of racks 104 may include any number and configuration of racks.

The at least two rack rows 106 may include at least a first rack row 106a arranged adjacent to a second rack row 106b. For example, the first rack row 106a may be positioned a predetermined distance d from the second rack row 106b. Although FIGS. 1A-1F depict a specific configuration of the at least two rack rows 106, it is contemplated herein that the modular data center system 100 may include any suitable configuration of the at least two rack rows 106 and the plurality of racks 104.

The distance d between the first rack row 106a and the second rack row 106b may form a hot aisle 108. For example, a depth of the hot aisle 108 may correspond to the predetermined distance d between the at least two rack rows 106.

For purposes of the present disclosure, the hot aisle 108 may be an area where the hot exhaust air from the IT equipment within the racks 104 (and other equipment) is collected and directed back to the cooling system. It is contemplated herein that the predetermined distance d between the at least two rack rows 106 may be based on a minimum distance for serviceability and power distribution. For example, the service area may be approximately 900 mm (or 3 ft). By way of another example, the service area may be approximately 800 mm.

The secondary fluid network 102 may be coupled to one or more coolant distribution units 110 (CDUs) of the liquid cooling system. For example, the modular data center system 100 may include two CDUs 110. For instance, each row 106 may include a CDU 110, where the first rack row 106a includes a first CDU 110a and the second rack row 106b includes a second CDU 110b arranged a distance from the first CDU 110a. Although FIG. 1A depicts the one or more CDUs 110 being arranged in a specific configuration within the secondary fluid network 102, it is contemplated herein that the one or more CDUs 110 may be arranged in any suitable configuration based on the arrangement and/or configuration of the liquid cooling system.

The one or more CDUs 110 may be configured to regulate the distribution of a cooling liquid of the liquid cooling system to maintain the temperature and pressure of the liquid within specific parameters. Further, the one or more CDUs 110 may be configured to separate primary chilled water loops from the secondary fluid network 102.

The secondary fluid network 102 includes one or more main pipelines 112. For example, the one or more main pipelines 112 may be arranged in the middle of the hot aisle 108. For instance, the secondary fluid network 102 may include two main pipelines 112, where a first main pipeline 112a is arranged a select distance above a second main pipeline 112b (as shown in FIGS. 1A-1B).

The one or more main pipelines 112 may be fluidically coupled to the one or more CDUs 110, such that the primary loop may be connected to the one or more CDUs 110. For example, each main pipeline 112a, 112b may be coupled to each CDU 110a, 110b. For instance, the first main pipeline 112a may be coupled to each of the first CDU 110a and the second CDU 110b, where the second main pipeline 112b may be coupled to each of the first CDU 110a and the second CDU 110b. In this regard, a first end of the first main pipeline 112a may be coupled to the first CDU 110a and a second end of the first main pipeline 112a may be coupled to the second CDU 110b. Further, a first end of the second main pipeline 112b may be coupled to the first CDU 110a and a second end of the second main pipeline 112b may be coupled to the second CDU 110b.

The secondary fluid network 102 includes one or more branch pipes 114. For example, the one or more branch pipes 114 may be fluidly connected to the one or more main pipelines 112. For instance, the one or more branch pipes 114 may be arranged perpendicular to each of the one or more main pipelines 112, such that the one or more branch pipes 114 are arranged vertically within the hot aisle 108 of the modular data center system 100. In a non-limiting example, a first set of branch pipes 114a may be coupled to the first main pipeline 112a and a second set of branch pipes 114b may be coupled to the second main pipeline 112b. Continuing with the above example, the first set of branch pipes 114a may be arranged proximate to the first rack row 106a and the second set of branch pipes 114b may be arranged proximate to the second rack row 106b. In this regard, the plurality of racks 104 within the first rack row 106a may be coupled to the first set of branch pipes 114a and the plurality of racks 104 within the second rack row 106b may be coupled to the second set of branch pipes 114b. It is contemplated herein that the number and/or arrangement of the one or more branch pipes 114 may be adjusted based on the number and/or configuration of the plurality of racks 104.

The one or more branch pipes 114 may be coupled to the plurality of racks 104 via one or more conduits 116. For example, the one or more main pipelines 112 may distribute chilled liquid (e.g., chilled water) from the one or more CDUs 110 to the one or more branch pipes 114 and subsequently distribute the chilled liquid to the plurality of racks 104 via the one or more conduits 116.

The one or more branch pipes 114 may include one or more valves 118. For example, the one or more valves 118 may be configured to selectively isolate each of the plurality of racks 104. For instance, the plurality of racks 104 may be hot-swapped into and/or out of the modular data center system 100. In this regard, IT equipment within a particular rack may be removed, replaced, or upgraded while the cooling system remains active, pressurized, and operational. As such, maintenance downtime may be reduced and cooling efficiency may be improved.

The secondary fluid network 102 may include a central support structure 122 configured to support the one or more branch pipes 114. For example, the central support structure 122 may be arranged within the middle of the hot aisle 108. For instance, the central support structure 122 may be arranged vertically along a substantially central axis within the middle of the hot aisle 108.

The secondary fluid network 102 may include a structure 124 installed within a portion of the hot aisle 108. For example, the structure 124 may be installed within a horizontal plane within the portion of the hot aisle 108 between the first rack row 106a and the second rack row 106b.

In embodiments, the structure 124 may include a grating structure 124 installed within a portion of the hot aisle 108, where the grating structure 124 includes one or more perforations that form a grating pattern. For example, the grating structure 124 may be a metal grating structure.

In some embodiments, the structure 124 may include a solid structure (i.e., without perforations). For example, the structure 124 may include one or more floor tiles. However, it is contemplated herein that the one or more perforations/gratings of the structure 124 may provide greater visibility and easier access beneath the structure 124.

The structure 124 may be installed a select distance above a floor 125 of the modular data center system 100, where at least a portion of the one or more conduits 116 may be arranged below the structure 124. For example, the one or more conduits 116 may couple to the IT equipment (e.g., below or above the floor 125) within the plurality of racks 104 that are installed on the floor 125 of the modular data center system 100, where the one or more conduits 116 may be routed below the structure 124 to couple to the one or more branch pipes 114. In this regard, a data center personnel may access one or more components of the secondary fluid network 102 (e.g., the one or more conduits 116 below the structure, the one or more main pipelines 112 above the hot aisle 108, the one or more branch pipes 114 within the hot aisle 108, the one or more valves 118 on the one or more branch pipes, or the like) via the structure 124.

The structure 124 may include one or more removable segments. For example, the one or more removable segments of the structure 124 may be removed to access components below the structure 124 (e.g., the one or more conduits 116 below the structure, the one or more main pipelines 112 above the hot aisle 108, the one or more branch pipes 114 within the hot aisle 108, the one or more valves 118 on the one or more branch pipes, or the like).

The secondary fluid network 102 may include one or more drain pans 126. For example, the one or more drain pans 126 may be arranged below the central support structure 122 and proximate to a connection point between an end of the one or more branch pipes 114 and the one or more conduits 116. In this regard, in the event of a leak, fluid from the secondary fluid network 102 may fall into the one or more drain pans 126 below the grating structure 124 rather than on the IT equipment within the plurality of racks 104.

In some embodiments, the secondary fluid network 102 may include one or more ultrasonic vibration units 127. For example, the one or more ultrasonic vibration units 127 may be coupled to the one or more branch pipes 114 (or the main pipelines 112) to agitate and dislodge contaminants, which can be captured or filtered by integrated filtration elements. For instance, the one or more ultrasonic vibration units 127 may include one or more piezoelectric transducers.

The modular data center system 100 may include one or more busbars 128 configured to provide power to the plurality of racks 104 of the at least two rack rows 106. For example, as shown in FIGS. 1C-1D, the one or more busbars 128 may be installed on the one or more walls 103 of the modular data center system 100. For instance, in a non-limiting example, the one or more busbars 128 may be installed on an interior surface of the one or more walls 103 of the modular data center system 100.

The one or more walls 103 of the modular data center system 100 may include a plurality of support members 130 configured to support the one or more busbars 128 and couple the one or more busbars 128 to the one or more walls 103. For example, each support member 130 may be horizontal and span some length of the enclosure 101 of the modular data center system. For instance, the plurality of support members 130 may be vertically stacked on the interior surface of the one or more walls 103, such that the modular data center system 100 may include rows of the one or more busbars 128 installed on the one or more walls 103 of the enclosure 101.

The one or more busbars 128 may include a set of busbars including at least two or more busbars. For example, at least a first set of busbars 128a of the one or more busbars 128 may be arranged proximate to the first rack row 106a and configured to provide power to the plurality of racks 104 of the first rack row 106a. By way of another example, a second set of busbars 128b of the one or more busbars 128 may be arranged proximate to the second rack row 106b and configured to provide power to the plurality of racks 104 of the second rack row 106b.

The one or more busbars 128 may include one or more tap-off boxes. The one or more tap-off boxes may allow distribution of power from the respective busbar 128 to the plurality of racks 104.

The enclosure 101 may include one or more frame support members 132 configured to provide at least partially support to the enclosure 101 and components within the enclosure 101 (e.g., equipment, secondary fluid network components, and the like). For example, the one or more frame support members 132 may include one or more vertical frame members to frame/support the wall 103 of the enclosure 101 and one or more horizontal frame members to frame/support a roof of the enclosure 101.

The enclosure 101 may further include a door 134 such that data center personnel may access the components within the enclosure 101 (e.g., equipment, secondary fluid network components, or the like).

It is contemplated herein that the secondary fluid network 102 of the present disclosure may provide a number of advantages/benefits. For example, the secondary fluid network 102 may have a compact design, meaning that the secondary fluid network 102 can fit into one module (or modular IT infrastructure/enclosure) while providing other benefits. In one instance, the compact design of the secondary fluid network 102 may provide easy accessibility of the valves 118 which are in the middle of the hot aisle 108. In this regard, the data center personnel can use the valves 118 immediately upon entering, as they are positioned in the middle of the hot aisle 108 on the vertical branch pipes 114. In another instance, the compact design of the secondary fluid network 102 may lower risk in the event of a leakage due to the drain pan 126 being below the smaller vertical pipes 114 and valves 118. If the leakage happens, the fluid from the secondary fluid network 102 may fall into the drain pan 126 below the grating structure 124, not on the IT equipment within the plurality of racks 104. Further, the modular data center system 100 may be modified to accommodate a higher number of racks and/or a higher rack density.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.
The disclosure comprises the following items:
1. A modular data center system comprising:
   a modular enclosure including a plurality of walls that define a cavity;
   at least two rack rows housed within the cavity of the modular enclosure, the at least two rack rows including at least a first rack row and a second rack row, wherein the first rack row is arranged a select distance from the second rack row to form a hot aisle, wherein each rack row includes a plurality of racks;
   one or more coolant distribution units configured to regulate a distribution of a coolant within the modular data center system; and
   a secondary fluid network coupled to the one or more coolant distribution units, wherein the secondary fluid network comprises:
      one or more main pipelines coupled to the one or more coolant distribution units, wherein the one or more main pipelines are arranged in a portion of the hot aisle;
      one or more branch pipes coupled to the one or more main pipelines, wherein the one or more branch pipes are arranged vertically with the hot aisle below the one or more main pipelines; and
      one or more conduits configured to couple the one or more branch pipes to the plurality of racks of the at least two rack rows,
      wherein the one or more main pipelines distribute the coolant from the one or more coolant distribution units to the one or more branch pipes, wherein the one or more branch pipes distribute the coolant to the plurality of racks via the one or more conduits.
2. The modular data center system of item 1, wherein the secondary fluid network further comprises:
   a structure installed within the hot aisle, wherein the structure is installed a select distance above a floor of the modular data center system.
3. The modular data center system of item 1 or item 2, wherein the structure is a grating structure including one or more perforations that form a grating pattern.
4. The modular data center system of any preceding item, wherein the one or more conduits are arranged below the structure.
5. The modular data center system of any preceding item, wherein the secondary fluid network further comprises:
   one or more drain pans arranged below the structure.
6. The modular data center system of any preceding item, wherein the one or more branch pipes include one or more valves, wherein the one or more valves are configured to selectively isolate each of the plurality of racks.
7. The modular data center system of any preceding item, further comprising:
   one or more busbars arranged adjacent to the first rack row and the second rack row, the one or more busbars configured to provide power to the plurality of racks of the first rack row and the second rack row.
8. The modular data center system of any preceding item, wherein the one or more busbars are coupled to at least two walls of the plurality of walls of the modular enclosure.
9. The modular data center system of any preceding item, wherein the plurality of racks includes data center support equipment.
10. The modular data center system of any preceding item, wherein the secondary fluid network further comprises:
   a central support structure configured to support the one or more branch pipes.
11. The modular data center system of any preceding item, wherein the secondary fluid network further comprises:
   one or more ultrasonic vibration units coupled to the one or more branch pipes, wherein the one or more ultrasonic vibration units are configured to agitate and dislodge contaminants within the one or more branch pipes.
12. A liquid cooling system comprising:
   one or more coolant distribution units configured to regulate a distribution of a coolant within the liquid cooling system; and
   a secondary fluid network coupled to the one or more coolant distribution units, wherein the secondary fluid network comprises:
      one or more main pipelines coupled to the one or more coolant distribution units, wherein the one or more main pipelines are arranged in a hot aisle formed by at least two rack rows including a plurality of racks;
      one or more branch pipes coupled to the one or more main pipelines, wherein the one or more branch pipes are arranged with the hot aisle below the one or more main pipelines; and
      one or more conduits configured to couple the one or more branch pipes to the plurality of racks of the at least two rack rows,
   wherein the one or more main pipelines distribute the coolant from the one or more coolant distribution units to the one or more branch pipes, wherein the one or more branch pipes distribute the coolant to the plurality of racks via the one or more conduits.
13. The liquid cooling system of item 12, wherein the liquid cooling system is a direct-to-chip liquid cooling system.
14. The liquid cooling system of item 12 or item 13, wherein the coolant includes chilled water.
15. The liquid cooling system of any of items 12-14, wherein the secondary fluid network further comprises:
   a structure installed within the hot aisle, wherein the structure is installed at a select distance above a floor of a data center enclosure.
16. The liquid cooling system of any of items 12-15, wherein the structure is a grating structure including one or more perforations that form a grating pattern.
17. The liquid cooling system of any of items 12-16, wherein the one or more conduits are arranged below the structure.
18. The liquid cooling system of any of items 12-17, wherein the secondary fluid network further comprises:
   one or more drain pans arranged below the structure.
19. The liquid cooling system of any of items 12-18, wherein the one or more branch pipes include one or more valves, wherein the one or more valves are configured to selectively isolate each of the plurality of racks.
20. The liquid cooling system of any of items 12-19, wherein the secondary fluid network further comprises:
   one or more ultrasonic vibration units coupled to the one or more branch pipes, wherein the one or more ultrasonic vibration units are configured to agitate and dislodge contaminants within the one or more branch pipes.

## Claims

1. A modular data center system comprising:
a modular enclosure including a plurality of walls that define a cavity;
at least two rack rows housed within the cavity of the modular enclosure, the at least two rack rows including at least a first rack row and a second rack row, wherein the first rack row is arranged a select distance from the second rack row to form a hot aisle, wherein each rack row includes a plurality of racks;
one or more coolant distribution units configured to regulate a distribution of a coolant within the modular data center system; and
a secondary fluid network coupled to the one or more coolant distribution units, wherein the secondary fluid network comprises:
one or more main pipelines coupled to the one or more coolant distribution units, wherein the one or more main pipelines are arranged in a portion of the hot aisle;
one or more branch pipes coupled to the one or more main pipelines, wherein the one or more branch pipes are arranged vertically with the hot aisle below the one or more main pipelines; and
one or more conduits configured to couple the one or more branch pipes to the plurality of racks of the at least two rack rows,
wherein the one or more main pipelines are configured to distribute the coolant from the one or more coolant distribution units to the one or more branch pipes, wherein the one or more branch pipes are configured to distribute the coolant to the plurality of racks via the one or more conduits.

2. The modular data center system of claim 1, wherein the secondary fluid network further comprises:
a structure installed within the hot aisle, wherein the structure is installed a select distance above a floor of the modular data center system.

3. The modular data center system of claim 2, wherein the structure is a grating structure including one or more perforations that form a grating pattern.

4. The modular data center system of claim 2 or claim 3, wherein the one or more conduits are arranged below the structure.

5. The modular data center system of any of claims 2-4, wherein the secondary fluid network further comprises:
one or more drain pans arranged below the structure.

6. The modular data center system of any preceding claim, wherein the one or more branch pipes include one or more valves, wherein the one or more valves are configured to selectively isolate each of the plurality of racks.

7. The modular data center system of any preceding claim, further comprising:
one or more busbars arranged adjacent to the first rack row and the second rack row, the one or more busbars configured to provide power to the plurality of racks of the first rack row and the second rack row.

8. The modular data center system of claim 7, wherein the one or more busbars are coupled to at least two walls of the plurality of walls of the modular enclosure.

9. The modular data center system of any preceding claim, wherein the plurality of racks includes data center support equipment.

10. The modular data center system of any preceding claim, wherein the secondary fluid network further comprises:
a central support structure configured to support the one or more branch pipes.

11. The modular data center system of any preceding claim, wherein the secondary fluid network further comprises:
one or more ultrasonic vibration units coupled to the one or more branch pipes, wherein the one or more ultrasonic vibration units are configured to agitate and dislodge contaminants within the one or more branch pipes.

12. The liquid cooling system of any preceding claim, wherein the one or more coolant distribution units and the secondary fluid network comprise a direct-to-chip liquid cooling system.

13. The liquid cooling system of any preceding claim, wherein the coolant includes chilled water.
